# EUROPEAN PATENT APPLICATION

(11) **EP 0 911 869 A2**
(43) Date of publication of application: **28.04.1999**
(21) Application number: 98308635.6
(22) Date of filing: 22.10.1998
(51) Int. Cl.: H01L 21/28, H01L 29/51

(54) **Low temperature method for forming a uniform thin oxide layer**

(30) Priority: 23.10.1997 US 63010 P
(71) Applicant: TEXAS INSTRUMENTS INCORPORATED, Dallas Texas 75265 (US)
(72) Inventor: Wilk, Glen D., Dallas Texas 75243 (US); Wallace, Robert M., Richardson Texas 75081 (US); Brar, Berinder P.S., Plano Texas 75025 (US)
(74) Representative: Legg, Cyrus James Grahame

(57) **Abstract**

This invention pertains generally to forming thin oxides at low temperatures, and more particularly to forming uniformly thick, thin oxides. We disclose a low temperature method for forming a thin, uniform oxide 16 on a silicon surface 12. This method includes providing a partially completed integrated circuit on a semiconductor substrate 10 with a clean, hydrogen terminated or atomically flat, silicon surface 12; and stabilizing the substrate at a first temperature. The method further includes exposing the silicon surface to an atmosphere 14 including ozone, while maintaining the substrate 10 at the first temperature. In this method, the exposing step creates a uniformly thick, oxide film 16. This method is suitable for room temperature processing.

## Description

### FIELD OF THE INVENTION

This invention pertains generally to forming thin oxides at low temperatures, and more particularly to forming thin oxides with high thickness uniformly.

### BACKGROUND OF THE INVENTION

Semiconductors are widely used in integrated circuits for electronic devices such as computers and televisions. These integrated circuits typically combine many transistors on a single crystal silicon chip to perform complex functions and store data. Semiconductor and electronics manufacturers, as well as end users, desire integrated circuits that can accomplish more functions in less time in a smaller package while consuming less power. Miniaturization is a common approach to help meet these goals.

With increasing miniaturization, one concern is the thickness of the gate dielectric used in conventional CMOS circuits. The current drive in a CMOS transistor is directly proportional to the gate capacitance. Since capacitance scales inversely with gate dielectric thickness, higher current drive requires continual reductions in thickness for conventional dielectrics. Present technology uses silicon dioxide (SiO₂) based films with thicknesses near 5 nm. However, projections suggest the need for 2 nm (20 Å) films for future small geometry devices.

### SUMMARY OF THE INVENTION

SiO₂ gate dielectrics in this thickness regime pose considerable challenges from a manufacturing perspective. Process control of the growth of a 2 nm film requires unprecedented thickness control. At these thicknesses direct tunneling through the SiO₂ may occur, although the effect of tunneling current on device performance may not preclude operation. Since the tunnel current depends exponentially on the dielectric thickness, small variations in process control may result in large variations in the tunnel current, possibly leading to reliability problems.

Another area of concern is the interface between the gate oxide and the channel region of the substrate. This silicon dioxide/silicon interface should be very flat and uniform to help limit interface scattering of electrons in the channel region.

Rapid thermal oxidation and furnace annealing are two current methods for forming gate oxides. However, current methods do not reliably produce gate oxides with the thickness uniformity and interface smoothness that will be needed to make devices with approximately 1.5 nm, 2 nm, or 2.5 nm gate oxides practical.

A low temperature method for forming a thin gate oxide on a silicon surface is disclosed herein. This method comprises providing a partially completed integrated circuit on a semiconductor substrate with a clean silicon surface; and stabilizing the substrate at a first temperature. The method further includes exposing the silicon surface to an atmosphere containing ozone, while maintaining the substrate at the first temperature. In this method, the exposing step creates a first, uniformly thick, gate oxide film.

Preferably, exposing the silicon surface to an atmosphere containing ozone includes exposing the silicon surface to an atmosphere containing molecular oxygen, while irradiating at least a portion of the atmosphere with ultraviolet light, where the light transforms some of the oxygen to ozone. In some embodiments, the atmosphere further includes an inert gas, such as argon. Preferably, the ozone at the silicon surface is not in an excited energy state, such as a plasma. However, a plasma kept away from the wafer may be more acceptable.

In some embodiments, the clean silicon surface is atomically flat. Typically, the semiconductor substrate contains some areas that already have some structure, such as a field oxide. In some embodiments, the substrate has a plurality of clean, atomically flat, silicon surfaces. This might occur when the gate oxide is applied to surfaces exposed by etching "windows" in a layer overlying a silicon surface; or when overlying layers are added to the silicon surface, except where "islands" have been masked off.

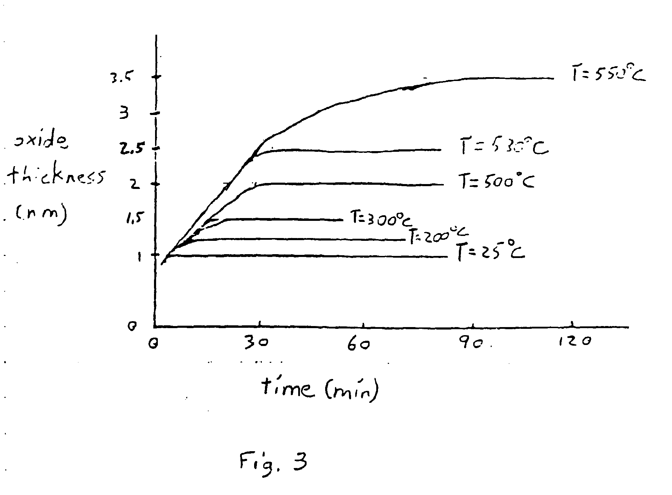

In some embodiments, the first temperature is about 25 degrees C and the oxide film has a thickness of about 10 angstroms. In other embodiments, the first temperature may be up to about 200 degrees C, or even up to 600 degrees C. These temperatures will grow thicker oxides (up to about 35 angstroms) as shown in Fig. 3.

In another aspect of this method, the method further includes depositing a uniformly thick layer of silicon on the first oxide film to form a temporary silicon layer, the temporary silicon layer having a thickness no greater than the potential thickness of oxidizable silicon. This potential thickness is found by determining a planned substrate temperature for a second oxide film formation, the planned temperature no greater than about 200 degrees C. This planned temperature substantially determines the potential thickness of oxidizable silicon. After depositing the silicon, the method further includes exposing the temporary silicon layer to a second atmosphere containing ozone, while the substrate is at the planned substrate temperature. This exposing step oxidizes the temporary silicon layer to form a second, uniformly thick, oxide film extending to the first oxide film; thereby creating a single (combined), uniformly thick, oxide film.

In some embodiments, the method further includes stabilizing the substrate at the planned substrate temperature before the exposing step.

### Brief Description Of The Drawings

The present invention will now be further described, by way of example, with reference to the accompanying drawings in which:

Fig. 1 shows a low temperature method for forming a very thin, uniform oxide layer.

Fig. 2 shows a low temperature method for forming a very thin, uniform oxide layer.

Fig. 3 shows a relationship between time, oxide thickness, and temperature.

Fig. 4 shows a field-effect transistor using a thin, uniform oxide layer as the gate dielectric.

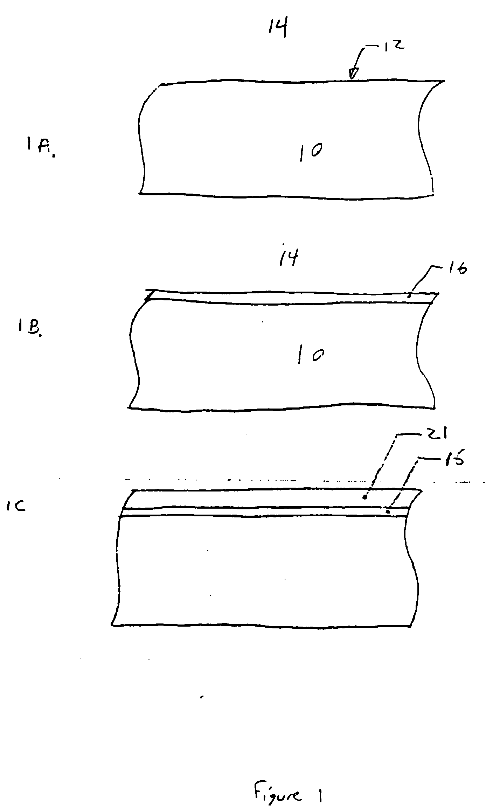

Fig. 1 outlines a method of using this invention to form a very thin, uniform SiO₂ gate dielectric on a silicon substrate. Initially, Si substrate 10 with a clean surface 12 is provided. Typically, this substrate 10 will include a partially completed integrated circuit with part of the surface 12 being either bare or hydrogen passivated silicon. This surface 12 may already have structures, such as field oxide regions, formed upon it, and other structures, such as diffusion regions formed in the substrate beneath it.

It has been found that a smooth, flat silicon surface tends to grow a more uniform oxide (particularly for very thin oxides) with this method. Thus, although a hydrogen terminated silicon surface usually produces acceptable results, many very thin, highly uniform silicon dioxide gate dielectrics prefer a silicon underlayer that approaches an atomically flat or atomically stepped surface. For our purposes, an atomically stepped surface will have a very low rms surface roughness, comparable to an atomically flat surface, in most areas. A wafer with an atomically stepped surface may have a series of adjacent flat surfaces (terraces). These terraces typically do not extend across a substrate wafer, and are not required to extend across a single device on a wafer. With very thin gate dielectrics, we sometimes prefer that adjacent terraces be connected by well-defined single- or double-atomic-height steps.

After the surface 12 is clean, but before exposure to an oxygen source, the substrate 10 temperature is stabilized at the oxidation temperature. This oxidation temperature substantially depends upon the thickness of the ozone-base oxide desired as shown in Fig. 3. This figure shows that for 1.0 nm oxides, the temperature should be near 25 degrees C. For a 2.0 nm oxide, the temperature should be approximately 500 degrees C. Similarly, 530 degrees C forms an approximately 2.5 nm oxide, while 550 degrees C forms an approximately 3.5 nm, high quality oxide. Fig. 3 was generated for UV-generated ozone in substantially pure oxygen at a 400 Torr O₂ pressure. Other ozone generation methods, or different oxygen pressures and/or concentrations may require adjustment of the temperature to yield a desired, precise oxide thicknesses.

This ability to grow precise, repeatable, usefully thick oxides at low temperatures greatly simplifies the temperature control problems. The ability to stabilize the whole wafer at the oxidation temperature allows for excellent process control, thus giving a uniform, repeatable oxidation thickness. Useful thermal oxides can be grown on wafers sitting in easily controlled furnaces. We have also found that this method is capable of producing oxides with good electrical properties. This ozone-based method can routinely achieve breakdown voltages above 10 MV/cm, such as 12 to 13 MV/cm.

The clean, temperature stabilized wafer with surface 12 is exposed to ozone 14. We have found that introducing molecular oxygen to the reaction chamber and exposing the oxygen to a mercury lamp (particular with 183 nm and 253 nm emission lines), generates sufficient quantities of ozone. Other ultraviolet sources or other non-energetic ozone sources can be substituted for the mercury lamp generated ozone. Energetic ozone sources can be used, but it is preferable to keep the any excited ozone species from contacting the wafer. We have found that methods that allow an ozone plasma to contact the wafer form oxides with poor electrical properties, such as a significantly lower breakdown voltage. The ozone plasma methods also tend to exhibit poor uniformity and have repeatability problems. In our non-plasma ozone-based method, the oxygen/ozone 14 pressure can be varied from below a microtorr to several atmospheres. We have found that pressures between several hundred torr and one atmosphere provide a simple method to provide good results. If desired, the oxygen/ozone 14 can be mixed with an inert gas, such as argon.

This ozone-based process forms a very uniform, substantially thick silicon dioxide layer 16 on the exposed silicon surface 12. This oxide layer 16 is much thicker than a conventional thermal oxide formed from exposing silicon to O₂ at the same temperature and time. Of even more importance, this oxide 16 is very repeatable and very uniform, primarily due to its self-limiting nature. When applied to a substantially flat silicon surface, this method repeatably produces SiO₂ layers with thickness uniformities better than 3% (better than 0.1 nm uniformity of an 3.0 nm thick oxide) across a 4 inch test wafer. Better heating uniformity can allow thickness uniformities below 1%. In fact, this method's oxide thickness uniformity will likely be limited in practice only by the heating uniformity, as opposed to the oxidation method itself. A typical transistor or capacitor layout will include a gate (or capacitor) electrode 21 superadjacent to the oxide 16.

Fig. 3 shows that this method has a very slight time dependent component. However, for most temperature/thickness combinations, the oxidation rate has already slowed dramatically after 30 to 60 minutes. Thus, this process is nearly self terminating with reasonable reaction times. As such, this method can be relatively insensitive to large variations in oxidation time.

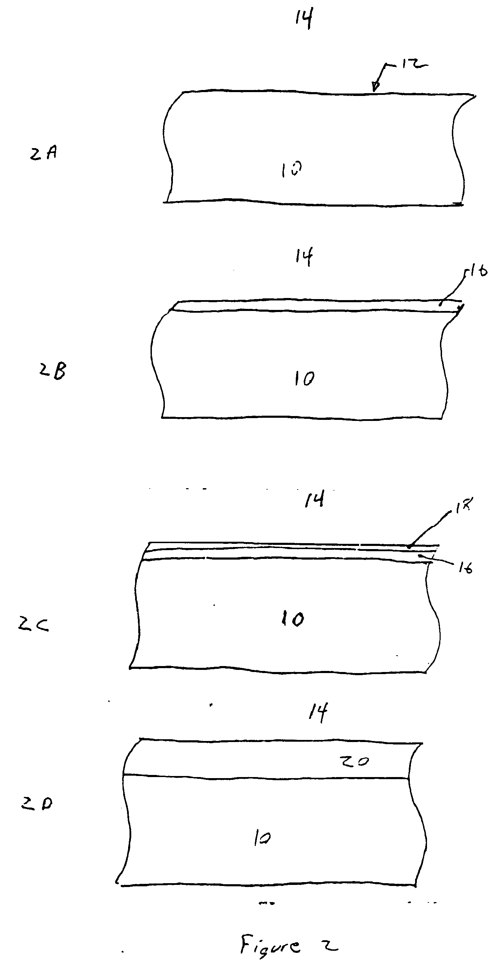

As the chart shows, higher temperatures will produce thicker oxides with this method. We have found that, if the thermal budget allows, we can easily produce high quality, 3.5 nm thermal oxides at only 550° C. Sometimes an artisan may prefer to use lower temperatures, but grow substantially thicker layers than shown in Fig. 3. For this case, we add extra steps as shown in Fig. 2, but still obtain a highly uniform oxide.

This variation involves first forming a highly uniform silicon dioxide layer 16 on a silicon surface 12 as described above. Next, a uniform silicon layer 18 is deposited on the silicon dioxide layer 16. The thickness and uniformity of the final oxide layer will depend upon the thickness of the silicon layer 18. Thus, silicon layer 18 should be formed with a well-controlled method, such as chemical vapor deposition or molecular beam epitaxy. This new silicon surface is then exposed to another ozone/oxygen atmosphere 14, forming a single SiO₂ layer 20. In this step, the total thickness of oxide layer 20 is determined by the thickness of the silicon 18 and the underlying SiO₂, layer 16. However, the ozone allows complete oxidation of much thicker silicon layers than a straight oxygen atmosphere. If necessary, this silicon deposition and oxidation can be repeated to form thicker layers.

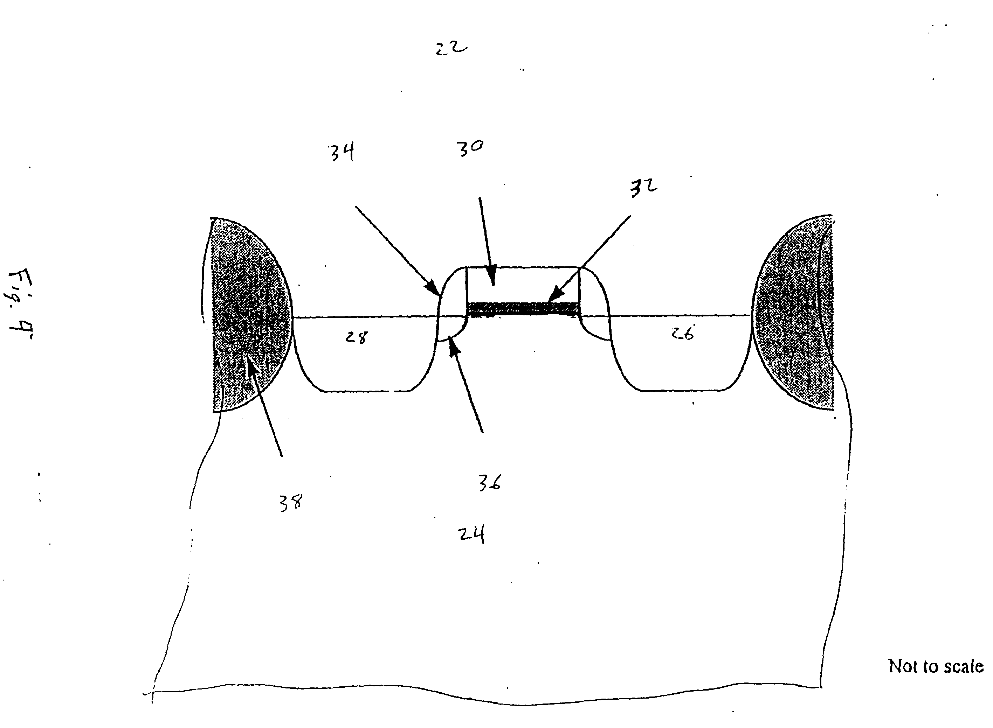

Fig. 4 shows a metal-oxide-silicon field-effect transistor (MOSFET) embodiment of this invention. Field-effect transistor 22 has four principal parts: a substrate 24, a source 26, a drain 28, and a gate, where the gate includes the gate electrode 30 and thin silicon dioxide gate dielectric 32. For an NMOS transistor 22, p-type silicon substrate 24 includes n+ source 26 and n+ drain 28 regions. Gate dielectric 32 is a very thin, very uniform, silicon dioxide film, formed by using ozone to oxidize the cleaned silicon substrate 24. MOSFET transistor 22 also includes sidewall spacers 34, lightly doped drain (LDD) region 36, and isolation region 38. Those skilled in the art will recognize that these and other features may be used or left out, depending upon the particular function of the device and the intended processing flow.

These examples have shown NMOS transistors. Since the ozone-based thin gate oxide method is substantially insensitive to the doping profile of Si, no special modifications are required to implement this invention in PMOS devices or CMOS devices; or into SiO₂ based capacitors, which require a thin, very uniform dielectric with low electrical leakage and a high breakdown voltage.

Although this method provides substantial benefits when used to form thin oxide layers, it can also offer an improvement over typical methods for forming thicker high-quality oxide layers, such as a dielectric around the floating gate in a flash memory cell. If the thermal budget permits, this ozone-based method can be used to form relatively thick SiO₂ layers in a single pass, or even thicker layers in a layered approach like that described above. Although these thicker layers may require temperature of 600 or 700 degrees C, this variation of the ozone-based method allows lower temperature processing than conventional oxidation processes. Not only do these lower temperatures help the thermal budget, but the self-limiting nature of a ozone-based process improves process repeatability and oxide thickness uniformity, without sacrificing the ozide's electrical quality.

The present invention has been described with several exemplary embodiments. However, various changes and modifications may be suggested to one skilled in the art.

## Claims

1. A low temperature method for forming a thin gate oxide on a silicon surface, the method comprising:
providing a partially completed integrated circuit on a semiconductor substrate with a clean, atomically flat, silicon surface;
stabilizing the substrate at a first temperature no greater than about 200 degrees C;
exposing the silicon surface to an atmosphere including ozone, while maintaining the substrate at the first temperature, wherein the exposing step creates a first, uniformly thick, gate oxide film.

2. The method of Claim 1, wherein the step of exposing the silicon surface to an atmosphere including ozone comprises:
exposing the silicon surface to an atmosphere including molecular oxygen, while irradiating at least a portion of the atmosphere with an ultraviolet light, the light being arranged to transform some of the oxygen to ozone.

3. The method of Claim 1 or Claim 2, wherein the step of providing the semiconductor substrate comprises providing a plurality of clean, atomically flat, silicon surfaces.

4. The method of any of Claims 1 to 3, wherein the step of stabilizing the substrate at a first temperature comprises stabilizing the substrate at a temperature of about 25 degrees C and the oxide film has a thickness of about 10 angstroms.

5. The method of any of Claims 1 to 3, wherein the step of stabilizing the substrate at a first temperature comprises stabilizing the substrate at a temperature of between 0 and 200 degrees C and the oxide film has a thickness between 5 and 20 angstroms.

6. The method of any of Claims 1 to 3, wherein the step of stabilizing the substrate at a first temperature comprises stabilizing the substrate at a temperature of about 200 degrees C.

7. The method of any preceding Claim, further comprising:
determining a planned substrate temperature for a second oxide film formation, the planned temperature no greater than about 200 degrees C; thereby substantially determining a potential thickness of oxidizable silicon;
depositing a uniformly thick layer of silicon on the first oxide film to form a temporary silicon layer, the temporary silicon layer having a thickness no greater than the potential thickness of oxidizable silicon;
exposing the temporary silicon layer to a second atmosphere including ozone, while the substrate is at the planned substrate temperature,
wherein the exposing step oxidizes the temporary silicon layer to form a second, uniformly thick, oxide film extending to the first oxide film; thereby creating a combined, uniformly thick, oxide film.

8. The method of Claim 7, further comprising:
stabilizing the substrate at the planned substrate temperature before the exposing step.

9. The method of Claim 7 or Claim 8, further comprising:
repeating the determining, depositing, and exposing at the planned temperature steps at least once; thereby increasing the thickness of the combined oxide film.

10. The method of any of Claims 7 to 9, wherein the step of stabilizing the substrate at a first temperature and the planned temperatures comprises stabilizing the substrate at a temperature of about 25 degrees C and the combined oxide film has a thickness of about 20 angstroms.

11. The method of any of Claims 1 to 10, further comprising forming a gate electrode on the gate oxide film.
